# EUROPEAN PATENT SPECIFICATION

(11) **EP 1 603 375 B1**
(45) Date of publication and mention of the grant of the patent: **06.03.2013**
(21) Application number: 05252366.9
(22) Date of filing: 15.04.2005
(51) Int. Cl.: H05K 1/11, H05K 3/34

(54) **Printed circuit board, method of soldering electronic components, and air conditioning apparatus with printed circuit board**
Leiterplatte, Verfahren zum Löten von elektronischen Bauteilen, und Klimagerät mit Leiterplatte
Panneau à circuit imprimé, procédé de soudure de composants électroniques, et appareil de climatisation comprenant un panneau à circuit imprimé

(30) Priority: 03.06.2004 JP 2004165621
(43) Date of publication of application: 07.12.2005
(73) Proprietor: MITSUBISHI DENKI KABUSHIKI KAISHA, Chiyoda-ku Tokyo 100-8310 (JP)
(72) Inventor: Miura, Tsuyoshi, c/o Mitsubishi Denki Kabushiki K., Tokyo 100-8310 (JP)
(74) Representative: Nicholls, Michael John

(56) References cited:
- EP-A- 0 660 650
- EP-A1- 1 542 517
- JP-A- 2002 280 717
- US-A- 4 544 238
- US-A1- 2003 156 391
- US-B1- 6 407 342
- PATENT ABSTRACTS OF JAPAN vol. 017, no. 615 (E-1459), 12 November 1993 (1993-11-12) & JP 05 191026 A (SANYO ELECTRIC CO LTD), 30 July 1993 (1993-07-30)
- PATENT ABSTRACTS OF JAPAN vol. 1997, no. 03, 31 March 1997 (1997-03-31) & JP 08 307022 A (FUJI ELECTRIC CO LTD), 22 November 1996 (1996-11-22)

## Description

The present invention relates to a printed circuit board on which a lead-attached electronic component is mounted by soldering using a flow-soldering bath.

Because in general a more populous mounted-component density on printed circuit boards is increasingly being required, board-mounting of narrow-pitch lead-attached electronic components has become necessary. On the other hand, there is an urgent need to implement the use of environment-friendly lead-free solder. However, the solderability of lead-free solder is poor compared to that of conventionally used lead-eutectic solder, which consequently has led to shorting due to solder between lead terminals of lead-attached electronic components.

Conventionally, for a printed circuit board of this type, in order to prevent solder bridges from being generated, a technique has been used in which adjacent lands are made so as to be different in size or form so that the surface tension of the solder is not balanced, whereby the solder is absorbed by either of the lands (e.g., see JP 24 3393/S62).

Moreover, another technique has been used in which both the lands on both outer ends are made so as to have larger areas than the other lands, whereby excess solder is absorbed by the two outer-end lands having the larger areas (e.g., see JP 15 7492/S63).

Furthermore, another technique has been used in which vacant lands are provided adjacent to soldering lands, rearward of a lead-attached electronic component perpendicularly disposed with respect to the flow - soldering direction, whereby excess solder is absorbed by the vacant lands (e.g., JP 300 588/H01).

JP 2002 280717 discloses an arrangement where a dummy pattern, where excess solder is attached, is provided at the rear of a plurality of soldering lands.

In the conventional lead-attached electronic component-mounting printed circuit boards described above, in order to maintain stable and high quality soldering for lead-attached electronic components in which solder bridges between leads are never generated, precise control of manufacturing processes is required. As the lead pitch becomes narrower, and when lead-free solder of poor solderability is used, soldering defects are more likely to be generated, and it has been difficult to maintain high accuracy.

The present invention is defined by the claims and is made in consideration of the problem described above, and aims to provide a printed circuit board that, even when narrow-pitch lead-attached electronic components are soldered, can prevent solder bridges between leads more assuredly under easier control, and can prevent soldering defects from being generated.

The invention will be further described by way of example with reference to the accompanying drawings, in which:-
Fig. 1 is a plan view illustrating a schematic configuration of a lead-attached electronic component-mounting printed circuit board, seen from the back side, according to Embodiment 1 of the invention;
Fig. 2 is a plan view illustrating a flow-soldering direction parallel arrangement of the lead-attached electronic component on the lead-attached electronic component-mounting printed circuit board according to Embodiment 1 of the invention;
Fig. 3 is a plan view illustrating a flow-soldering direction perpendicular arrangement of the lead-attached electronic component on the lead-attached electronic component-mounting printed circuit board according to Embodiment 1 of the invention;
Fig. 4 is an enlarged plan view of key components of the lead-attached electronic component-mounting printed circuit board according to Embodiment 1 of the invention, illustrating the relationship between a group of soldering lands and a rearward solder-drawing land;
Fig. 5 is a flowchart illustrating processes for a flow soldering operation for the lead-attached electronic component-mounting printed circuit board according to Embodiment 1 of the invention; and
Fig. 6 is a schematic front view illustrating an air conditioning apparatus in which a lead-attached electronic component-mounting printed circuit board according to Embodiment 1 of the invention is installed.

### Embodiment 1.

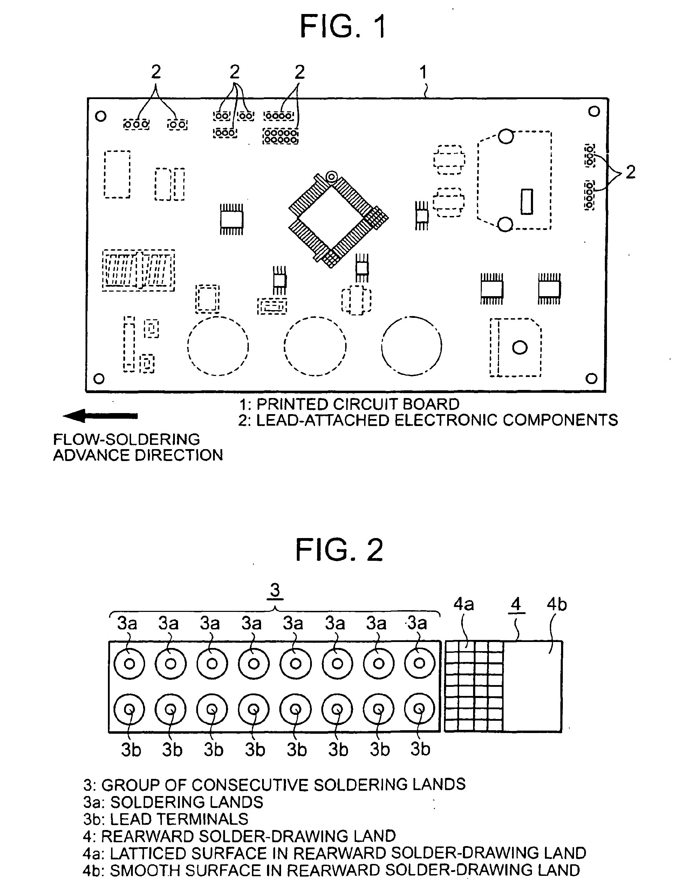

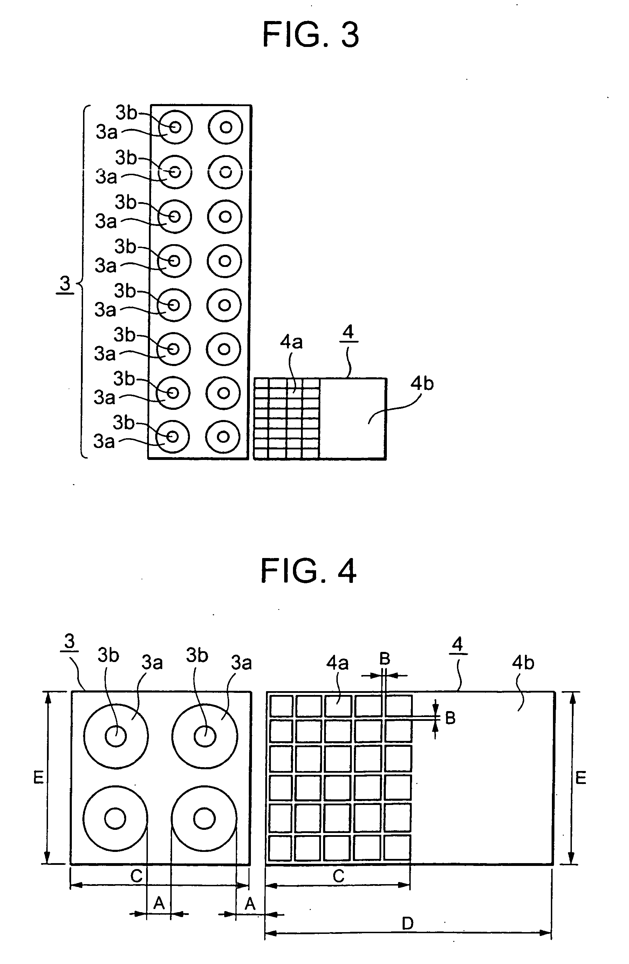

Hereinafter, a lead-attached electronic component-mounting printed circuit board according to Embodiment 1 of the present invention will be described using Fig. 1 through Fig. 4. Here, Fig. 1 is a plan view illustrating a schematic configuration of the lead-attached electronic component-mounting printed circuit board, seen from the back side, according to Embodiment 1 of the invention; Fig. 2 is a plan view illustrating a flow-soldering direction parallel arrangement of the lead-attached electronic component on the lead-attached electronic component-mounting printed circuit board according to Embodiment 1 of the invention; Fig. 3 is a plan view illustrating a flow-soldering direction perpendicular arrangement of the lead-attached electronic component on the lead-attached electronic component-mounting printed circuit board according to Embodiment 1 of the invention; and Fig. 4 is an enlarged plan view of key components of the lead-attached electronic component-mounting printed circuit board according to Embodiment 1 of the invention, illustrating the relationship between a group of soldering lands and a rearward solder-drawing land.

On the printed wiring board 1 in the figure, components that are automatically mounted on the front face (e.g., a chip resistor, a chip capacitor, a chip diode, a discrete resistor, a discrete capacitor, a discrete diode, etc.), and components that are inserted manually (e.g., a large resistor, a hybrid IC, a transformer, a coil, a large-capacity semiconductor, a large capacitor, etc.)―none of these is illustrated in the figure―are disposed.

In addition, on the reverse face of the printed circuit board 1, on which a copper foil (not illustrated) is provided, lead-attached electronic components 2 are mounted and attached so that the components are disposed in parallel or perpendicularly with respect to the direction indicated by an arrow, namely, to the flow soldering advance direction.

For each of the lead-attached electronic components 2, a group 3 of consecutive soldering lands is provided. In cases in which a lead-attached electronic component 2 is disposed in parallel with the flow soldering advance direction, a rearward solder-drawing land 4 whose front half is a latticed surface and whose rear half is a smooth surface is provided rearward of the group 3 of consecutive soldering lands. In cases in which a lead-attached electronic component 2 is disposed perpendicularly to the flow soldering advance direction, a rearward solder-drawing land 4 whose front half is a latticed surface and whose rear half is a smooth surface is provided rearward of a portion of the group 3 of consecutive soldering lands.

Features of the printed circuit board 1 according to Embodiment 1 of the invention lie in the difference, from printed circuit boards of the conventional technology, in form and arrangement of the rearward solder-drawing land, and in the difference in the land geometry of the group 3 of consecutive soldering lands.

More specifically, as illustrated in Fig. 4, the rearward solder-drawing land 4 in the printed circuit board according to Embodiment 1 of the invention is disposed at a spacing that is approximately the same as the interval A between lands in the group 3 of consecutive soldering lands, and includes a lattice-shaped solder-drawing portion having approximately the same area as the footprint of extent C of a two-land width times extent E of a two-land depth in the group 3 of consecutive soldering lands, and a smooth-surface portion for removing solder voids, having approximately the same area as the solder-drawing portion.

In addition, the latticed surface in the rearward solder-drawing land 4 is preferably formed so that the interval B between adjacent lattice spaces is within 0.3 mm.

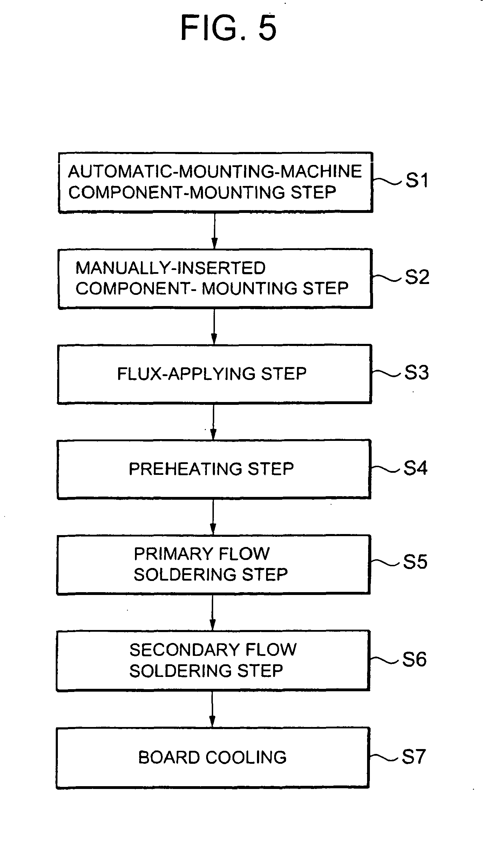

Next, Fig. 5 is a flowchart illustrating processes for a flow soldering operation for the lead-attached electronic components. The soldering, using a flow-soldering bath, of the lead-attached electronic components 2 on the printed circuit board 1 configured as described above will be described according to Fig. 5. Firstly, in Embodiment 1 of the invention, according to experiment and analysis, on the front face and the reverse face of the printed circuit board 1, in an automatic-mounting-machine component-mounting step in step S1, automatically-mounted components (e.g., a chip resistor, a chip capacitor, a chip diode, a discrete resistor, a discrete capacitor, a discrete diode, etc.)―not illustrated in the figures―and lead-attached electronic components 2 for automatic mounting are set into place by means of an automatic mounting machine. Next, in a manually-inserted component-mounting step in step S2, manually-inserted components (e.g., a large resistor, a hybrid IC, a transformer, a coil, a large-capacity semiconductor, a large capacitor, etc.) and lead-attached electronic components 2 for manual mounting are manually inserted and attached.

Next, in a flux-applying step in step S3, a flux activator is applied to the reverse face of the lead-attached electronic component-mounting printed circuit board 1 so that the solder will take to the copper foil. Then, in preheating step in step S4, the flux that has been applied in step S3 is heated so as to reach the best activation temperature.

After that, in a primary flow soldering step in step S5, a solder-jetting means for jetting solder like fountain water from a nozzle with a number of holes solders equally all around lead portions of the components on the reverse face of the lead-attached electronic component-mounting printed circuit board 1.

When the primary flow soldering step in step S5 is completed, in a secondary flow soldering step in step S6, solder that has bridged between leads of components by the primary flow soldering step is removed by the printed board being passed, in the direction of the arrow illustrated in Fig. 1, across the liquid surface of a soldering bath having a flat liquid surface of the solder. Finally, in board cooling in step S7, when the lead-attached electronic component printed circuit board 1 that has been soldered is cooled, then the processes are completed.

The lead-attached electronic components 2 that have been mounted are disposed in parallel with respect to the flow soldering advance direction, and when the printed circuit board is proceeding into the solder jetting portion in the flow-soldering bath, the solder flows rearwards along each of the soldering lands 3a in the group 3 of consecutive soldering lands for each of the lead-attached electronic components 2. On this occasion, the solder moves rearwards while successively making bridges due to the action of surface/boundary tension between the individual lead terminals 3b of each of the lead-attached electronic components 2. The solder in the rear portion of the group 3 of consecutive soldering lands is sucked in by the rearward solder-drawing land 4, but therein, solder once having been sucked in by the rearward solder-drawing land 4 is, due to the action of the solder surface/boundary tension, subjected to a force that draws it back to the solder in the rear portion of the group 3 of consecutive soldering lands.

Here, the rearward solder-drawing land 4 proposed in Embodiment 1 is disposed at a spacing that is approximately the same as the interval A between lands in the group 3 of consecutive soldering lands, and by giving the land a layout that includes a rearward-solder-drawing-land latticed surface 4a, the size of which is approximately the same area as the footprint of extent C of a two-land width times extent E of a two-land depth in the group 3 of consecutive soldering lands, and a smooth surface 4b, of approximately the same area as the latticed surface 4a of the solder-drawing land, for removing solder voids, the solder is readily sucked in by the rearward solder-drawing land 4, and the surface/boundary tension of the solder, once having been sucked in by the rearward solder-drawing land 4, is dispersed, which decreases the force drawing the solder back to the group 3 of consecutive soldering lands. Consequently, solder bridges in the group 3 of consecutive soldering lands substantially diminish in number. Moreover, it has been confirmed from a result of a trial production and its evaluation that providing the smooth surface in the rear portion of the rearward solder-drawing land 4 is beneficial in that void solder chips are prevented from being generated, making it possible to eliminate post-processing manual reworking to remove voids, which is beneficial in that cutting down on manufacturing steps can be realized.

It has been confirmed by the inventor that if the rearward solder-drawing land 4 is not made in lattice form, and, as in conventional embodiments, only the shape of the group 3 of consecutive soldering lands is changed or only both the outer-end lands are made large, much more solder short circuits are generated in the group 3 of consecutive soldering lands compared with this embodiment of the invention, with the phenomenon being especially significant for a dual-in-line lead-attached electronic component, and that void solder chips are generated if the rearward solder-drawing land 4 has only a lattice form without having a smooth surface in the rear portion.

Moreover, when the lead-attached electronic component is mounted so as to be disposed perpendicularly to the flow soldering advance direction and the printed circuit board is proceeding into the solder-jetting portion of the flow-soldering bath, because the solder flows perpendicularly to the orientation in which the lands in the group 3 of the soldering lands for the lead-attached electronic component 2 line up, the force drawing the solder to rearward of each soldering land 3a is weak; whereby more solder bridges are generated compared with the parallel arrangement.

Here, by arranging the rearward solder-drawing land 4 proposed in Embodiment 1, of similar form as in the parallel arrangement, to be disposed rearward of a portion of the group 3 of consecutive soldering lands, without there being interference with circuit pattern lines leading out of the group 3 of the soldering lands, the solder in each land in the soldering-land group 3 is readily sucked in by the rearward solder-drawing land 4, and the surface/boundary tension of solder once having been sucked in by the rearward solder-drawing land 4 is dispersed so that the force drawing the solder back to the group 3 of consecutive soldering lands decreases. Consequently, solder bridges substantially diminish in number without affecting leading circuit pattern lines out of the group 3 of consecutive soldering lands. It has been confirmed by the inventor that, if only the shape of the group 3 of the soldering lands is changed without providing the rearward solder-drawing land 4, or if solder-drawing lands are provided corresponding to each of the lands in the group 3 of soldering lands, in particular, for a dual-in-line lead-attached electronic component, much more solder short circuits are generated in the group 3 of the soldering lands compared with this embodiment of the invention.

As described above, according to the lead-attached electronic component-mounting printed circuit board of the invention, benefits can be achieved in that when using the flow-soldering bath to solder lead-attached electronic components, solder short circuits that are generated by the solder moving rearwards while creating bridges due to surface/boundary tension can be eliminated more assuredly, and in that the number of points in which solder short circuits are generated can be reduced.

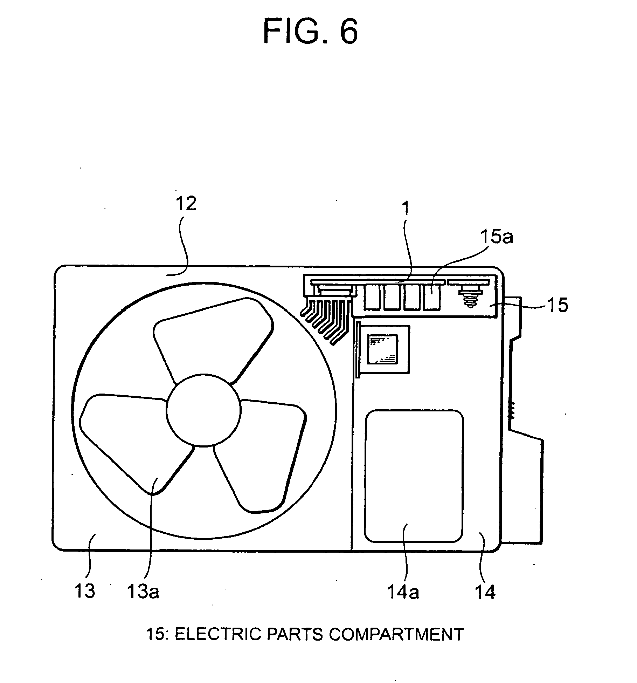

Fig. 6 is a schematic front view illustrating an outdoor unit of an air conditioning apparatus, in which according to the other embodiments of the invention a lead-attached electronic component-mounting printed circuit board is installed. In the figure, the outdoor unit 12 of the air conditioning apparatus is configured with a fan chamber 13 equipped with a fan 13a, a compressor chamber 14 including a compressor 14a and an electric parts compartment 15 that is flat in form; and the lead-attached electronic component-mounting printed circuit board 1 is disposed in the electric parts compartment 15, with its front face on which electric parts 15a are mounted being downward, and with its reverse face that is planar and has the copper foil being upward.

Accordingly, the electric parts compartment in which according to the other embodiments of the invention the lead-attached electronic component-mounting printed circuit board 1 is disposed can be configured to be flat in form in the heightwise orientation, which is beneficial in that the layout space can be made compact by flattening the electric parts compartment in the compressor chamber of the outdoor unit of the air conditioning apparatus, in that the flexibility in locating space for other parts is increased, and in that the assembly work can be carried out with enough room.

## Claims

1. A printed circuit board (1) on which an electronic component (2) mounts and that includes a group of consecutive soldering lands (3) for the electronic component (2), the electronic component (2) having a plurality of leads, being attached by soldering using a flow-soldering bath and sitting in parallel with or perpendicular to a flow soldering direction, wherein the printed circuit board (1) comprises
a rearward solder-drawing land (4) being provided adjacent to the tail end of the group of consecutive soldering lands (3) **characterized in that** the solder-drawing land (4) has a lattice form (4a).

2. The printed circuit board (1) according to claim 1, **characterized in that**:
the rearward solder-drawing land (4) has the lattice form (4a) and a smooth surface (4b).

3. The printed circuit board (1) according to claim 2, **characterized in that**:
the lattice form (4a) and the smooth surface (4b) are respectively disposed on a front side and a rear side of the rearward solder drawing land (4) in light of the flow soldering direction.

4. A method of soldering an electronic component that mounts on a printed circuit board (1), the printed circuit board (1) including a group of consecutive soldering lands (3) for the electronic component (2), the electronic component (2) having a plurality of leads, being attached to the printed circuit board (1) by soldering using a flow-soldering bath and sitting in parallel with or perpendicular to a flow soldering direction, the method comprising:
a step for placing, by means of an automatic mounting machine, the electronic component (2) on the reverse face of the printed circuit board (1);
a step for applying a flux activator to the reverse face of the printed circuit board (1);
a step for heating the flux to an appropriate activation temperature;
a soldering step for soldering lead portions of the electronic component (2) uniformly onto the reverse face of the printed circuit board (1); and
a step for removing solder that has bridged between the leads in the soldering step by means of a rearward solder drawing land (4) in a lattice form (4a), the rearward solder drawing land (4) being located adjacent to the group of the consecutive soldering lands (3).

5. The method according to claim 4, further comprising
a step for manually placing components on the reverse face of the printed circuit board (1),
wherein another electronic component is placed on the front face of the printed circuit board in the step for placing.

6. An air conditioning apparatus including:
an outdoor unit (12) having a fan chamber (13) and a compressor chamber (14);
an electric parts compartment (15) arranged in the upper portion of the compressor chamber (14), the electric parts compartment (15) comprising the printed circuit board (1) according to claim 1.

## Patentansprüche

1. Gedruckte Leiterplatte (1), auf der eine elektronische Komponente (2) befestigt ist und die eine Gruppe von aufeinanderfolgenden Lötaugen (3) für die elektronische Komponente (2) beinhaltet, wobei die elektronische Komponente (2) eine Vielzahl von Anschlüssen aufweist, die durch Löten unter Verwendung eines Schwalllötbades befestigt sind und parallel oder senkrecht zu einer Schwalllötrichtung sitzen, wobei die gedruckte Leiterplatte (1) ein rückwärtiges Lötmittelabzugsauge (4) umfasst, das benachbart zum Ende der Gruppe von aufeinanderfolgenden Lötaugen (3) angeordnet ist,
**dadurch gekennzeichnet, dass**
das Lötmittelabzugsauge (4) eine Gitterform (4a) aufweist.

2. Gedruckte Leiterplatte (1) nach Anspruch 1, **dadurch gekennzeichnet, dass** das rückwärtige Lötmittelabzugsauge (4) die Gitterform (4a) und eine glatte Oberfläche (4b) aufweist.

3. Gedruckte Leiterplatte (1) nach Anspruch 2, **dadurch gekennzeichnet, dass** die Gitterform (4a) und die glatte Oberfläche (4b) jeweils auf einer Vorder- und einer Rückseite des rückwärtigen Lötmittelabzugsauges (4) angesichts der Schwalllötrichtung angeordnet sind.

4. Verfahren zum Löten einer elektronischen Komponente, die auf einer gedruckten Leiterplatte (1) befestigt ist, wobei die gedruckte Leiterplatte (1) eine Gruppe von aufeinanderfolgenden Lötaugen (3) für die elektronische Komponente (2) beinhaltet, wobei die elektronische Komponente (2) eine Vielzahl von Anschlüssen aufweist, die durch Löten unter Verwendung eines Schwalllötbades an der gedruckten Leiterplatte (1) befestigt sind und parallel oder senkrecht zu einer Schwalllötrichtung sitzen, wobei das Verfahren umfasst:
einen Schritt zum Platzieren der elektronischen Komponente (2) auf der Rückseite der gedruckten Leiterplatte (1) mittels eines Bestückungsautomaten;
einen Schritt zum Applizieren eines Schmelzmittelaktivators auf der Rückseite der gedruckten Leiterplatte (1);
einen Schritt zum Erwärmen des Schmelzmittels auf eine angemessene Aktivierungstemperatur;
einen Lötschritt zum gleichmäßigen Löten von Teilen des Anschlusses der elektronischen Komponente (2) auf die Rückseite der gedruckten Leiterplatte (1); und
einen Schritt zum Entfernen von Lötmittel, welches im Lötschritt eine Brücke zwischen den Anschlüssen geschaltet hat, mittels eines rückseitigen Lötmittelabzugsauges (4) in einer Gitterform (4a), wobei sich das rückseitige Lötmittelabzugsauge (4) benachbart zur Gruppe von aufeinanderfolgenden Lötaugen (3) befindet.

5. Verfahren nach Anspruch 4, weiter beinhaltend:
einen Schritt zum manuellen Platzieren von Komponenten auf der Rückseite der gedruckten Leiterplatte (1),
wobei eine weitere elektronische Komponente auf der Vorderseite der gedruckten Leiterplatte in dem Schritt zum Platzieren platziert wird.

6. Klimatisierungsgerät beinhaltend:
eine Außeneinheit (12) mit einer Gebläsekammer (13) und einer Kompressorkammer (14);
einer Abteilung (15) für elektrische Teile, die im oberen Teil der Kompressorkammer (14) angeordnet sind, wobei die Abteilung (15) für elektrische Teile die gedruckte Leiterplatte (1) nach Anspruch 1 umfasst.

## Revendications

1. Carte de circuit imprimé (1) sur laquelle est monté un composant électronique (2) et qui comprend un groupe de plages de soudure consécutives (3) pour le composant électronique (2), le composant électronique (2) présentant une pluralité de fils, fixés par soudage en utilisant un bain de soudure à la vague et qui sont placés parallèles ou perpendiculaires à la direction de soudure à la vague, dans laquelle la carte de circuit imprimé (1) comprend :
une plage d'étirage de soudure arrière (4) disposée adjacente à l'extrémité arrière du groupe de plages de soudure consécutives (3), **caractérisé en ce que** la plage d'étirage de soudure (4) présente une forme en treillis (4a).

2. Carte de circuit imprimé (1) selon la revendication 1, **caractérisée en ce que** :
la plage d'étirage de soudure arrière (4) présente une forme en treillis (4a) et une surface lisse (4b).

3. Carte de circuit imprimé (1) selon la revendication 2, **caractérisée en ce que** :
la forme en treillis (4a) et la surface lisse (4b) sont disposées respectivement sur un côté avant et sur un côté arrière de la plage d'étirage de soudure arrière (4) à la lumière de la direction de soudure à la vague.

4. Procédé de soudage d'un composant électronique qui est monté sur une carte de circuit imprimé (1), la carte de circuit imprimé (1) comprenant un groupe de plages de soudure consécutives (3) pour le composant électronique (2), le composant électronique (2) présentant une pluralité de fils, fixés sur la carte de circuit imprimé (1) par soudage en utilisant un bain de soudure à la vague et en les plaçant parallèles ou perpendiculaires à la direction de soudure à la vague, le procédé comprenant :
une étape consistant à placer, à l'aide d'une machine de montage automatique, le composant électronique (2) sur la face opposée de la carte de circuit imprimé (1) ;
une étape consistant à appliquer un activateur de flux sur la face opposée de la carte de circuit imprimé (1) ;
une étape consistant à chauffer le flux à une température d'activation appropriée ;
une étape de soudage consistant à souder les parties de fil du composant électronique (2) de manière uniforme sur la face opposée de la carte de circuit imprimé (1) ; et
une étape consistant à retirer la soudure déposée en ponts entre les fils dans l'étape de soudage au moyen d'une plage d'étirage de soudure arrière (4) en forme de treillis (4a), la plage d'étirage de soudure arrière (4) étant située adjacente au groupe de plages de soudure consécutives (3).

5. Procédé selon la revendication 4, comprenant en outre :
une étape consistant à placer manuellement des composants sur la face opposée de la carte de circuit imprimé (1) ;
dans lequel un autre composant électronique est placé sur la face avant de la carte de circuit imprimé dans l'étape de placement.

6. Appareil de climatisation comprenant :
une unité extérieure (12) présentant une chambre de ventilateur (13) et une chambre de compresseur (14) ;
un compartiment de pièces électriques (15) agencé dans la partie supérieure de la chambre de compresseur (14), le compartiment de pièces électriques (15) comprenant la carte de circuit imprimé (1) selon la revendication 1.
